# EUROPÄISCHE PATENTSCHRIFT

(11) **EP 1 789 607 B1**
(45) Veröffentlichungstag und Bekanntmachung des Hinweises auf die Patenterteilung: **17.03.2010**
(21) Anmeldenummer: 05787448.9
(22) Anmeldetag: 07.09.2005
(51) Int. Cl.: C23C 30/00, C23C 14/08, C23C 16/40

(54) **SCHNEIDWERKZEUG MIT OXIDISCHER BESCHICHTUNG**
CUTTING TOOL WITH OXIDE COATING
OUTIL DE COUPE A COUCHE D'OXYDE

(30) Priorität: 14.09.2004 DE 102004044240
(43) Veröffentlichungstag der Anmeldung: 30.05.2007
(73) Patentinhaber: WALTER Aktiengesellschaft, 72072 Tübingen (DE)
(72) Erfinder: SCHIER, Veit, 70771 Echterdingen (DE)
(74) Vertreter: Rüger, Barthelt & Abel Patentanwälte
(86) Internationale Anmeldenummer: PCT/EP2005/009595
(87) Internationale Veröffentlichungsnummer: WO 2006/029747

(56) Entgegenhaltungen:
- WO-A-92/17623
- WO-A-93/20257
- WO-A-2004/029321
- WO-A-2004/033751
- US-A- 4 746 563
- US-A- 5 447 804
- US-A- 5 766 782
- US-A1- 2004 081 824
- PATENT ABSTRACTS OF JAPAN Bd. 2000, Nr. 08, 6. Oktober 2000 (2000-10-06) & JP 2000 129445 A (SUMITOMO ELECTRIC IND LTD), 9. Mai 2000 (2000-05-09)
- PATENT ABSTRACTS OF JAPAN Bd. 2003, Nr. 12, 5. Dezember 2003 (2003-12-05) & JP 2004 001154 A (HITACHI TOOL ENGINEERING LTD), 8. Januar 2004 (2004-01-08)

## Beschreibung

Die Erfindung betrifft ein Schneidwerkzeug mit einem Schichtaufbau, zu dem zumindest eine Oxidschicht gehört.

Es ist bekannt, Schneidwerkzeuge zur Erhöhung der Standfestigkeit oder auch zur Verbesserung der Schneideigenschaften mit einem Schichtaufbau zu versehen, der bspw. metallische Hartstoffschichten, Oxidschichten oder dergleichen enthält. Zur Beschichtung werden CVD-Verfahren (chemical vapor deposition) wie auch PVD (physical vapor deposition) angewendet. Auch existieren Hybridverfahren. Die CVD-Verfahren sind im Wesentlichen darauf beschränkt, stabile Phasen gewünschter Verbindungen als Oberflächenschichten abzulagern. Mit PVD-Verfahren oder Hybridverfahren, lassen sich auch metastabile Phasen von Verbindungen als Schicht ablagern.

Aus der DE 196 51 592 A1 ist ein beschichtetes Schneidwerkzeug mit einem mehrlagigen Schichtaufbau bekannt. Die in verschiedenen Ausführungsbeispielen angegebenen Schichtaufbauten enthalten u.a. zumindest eine Aluminiumoxidschicht sowie metallische Hartstoffschichten. Die metallischen Hartstoffschichten sind bspw. in PVD abgeschiedene TiAlN-Schichten. Auch die z.B. darauf direkt aufgebrachte Aluminiumoxidschicht ist im PVD-Verfahren abgeschieden.

Aluminiumoxidschichten sind binäre Oxidschichten, die in der Praxis gute Ergebnisse liefern. Es wird jedoch angestrebt diese zu verbessern. Aus der EP 1253215 A2 ist ein im PVD-Verfahren mit Aluminiumoxid beschichtetes Schneidwerkzeug bekannt, wobei weitere Schichten, wie bspw. TiN-Schichten vorhanden sein können.

Auch hier gilt es die Eigenschaften der Al₂O₃-Schicht zu verbessern.

Aus der DE 199 42 303 A1 ist ein Schneideinsatz bekannt, der eine mehrphasige Aluminiumoxidschicht enthält. Die im CVD-Verfahren hergestellte Schicht enthält Al₂O₃ (mehrphasige Aluminiumoxidschicht). Die im CVD-Verfahren hergestellte Schicht enthält Al₂O₃ (Aluminiumoxid) ZrO₂ (Zirkonoxid) sowie eine dritte feindispersive Phase bestehend aus einem Oxid, Oxodkarbid, Oxodnitrit oder Oxocarbonitrid des Titans.

Die DE 197 37 470 A1 offenbart einen Schneidkörper mit einer Beschichtung, zu der wenigstens eine mehrphasige Schicht gehört. Der im CVD-Verfahren erzeugte Schichtaufbau enthält z.B. eine Zirkoncarbonitridschicht (kubisches ZrCN) und ZrO₂ in monokliner und/oder tetragonaler Form.

Während die kristalline ZrCN-Matrix als harte Beschichtung wirkt, wirkt das eingelagerte ZrO₂ als Trockenschmierstoff.

Aus der DE 196 41 468 A1 ist ebenfalls ein Verbundkörper, bspw. ein Schneidwerkzeug bekannt, der eine mehrlagige Beschichtung enthält. Die Beschichtung enthält dünnlagige Al₂O₃-Schichten und/oder ZrO₂-Schichten.

Die DE 195 18 927 offenbart Schneideinsätze mit mehrlagigem Schichtaufbau, die im CVD-Verfahren hergestellt sind. Die Schneideinsätze sind mit einem so genannten Verbundkeramik-Überzug versehen, der eine kontinuierliche Metalloxid-Phase und eine diskontinuierliche Metalloxid-Phase enthält. Es handelt sich somit um eine zweiphasige Metalloxidschicht, die bspw. aus einer kontinuierlichen Al₂O₃-Phase besteht, in die diskrete ZrO₂-Teilchen oder Y₂O₃-Teilchen eingelagert sind.

Der kristalline Aufbau der kontinuierlichen Phase bestimmt die Schichteigenschaften und führt somit in der Regel zu einigermaßen harten dabei aber spröden Schichten.

Die US 5 447 804 A offenbart eine Hartstoffbeschichtung in Form einer (Al, Cr)₂O₃-Schicht, die in einem CVD- oder in einem PVD-Prozess hergestellt worden ist. Ziel des in der genannten Schrift angegebenen Verfahrens ist die Herstellung einer α-Aluminiumoxidschicht, d.h. einer Aluminiumoxidschicht mit α-Kristallstruktur. Hierzu sind normalerweise sehr hohe Temperaturen von 1000°C oder mehr erforderlich. Der Vorschlag gemäß der genannten US-Schrift geht dahin, die Schicht mit einem hohen Chromanteil von mehr als 5 % zu versehen. Chrom wirkt hier als α-Phasenbildner.

Darüber hinaus offenbart die US 4 746 563 A eine (Al Ti)₂O₃-Schicht, bei der der Titangehalt entweder auf einen geringen Anteil von 0,01 bis 0,1 vol% beschränkt ist oder einen höheren Wert aufweist. Bei der Beschränkung auf 0,01 bis 0,1 vol% ist das Titan in der Aluminiumoxidschicht als Festkörper gelöst. In höheren Anteilen wird das Titan in der Aluminiumoxidschicht untergebracht, indem eine relativ dicke Al₂O₃-Schicht von beispielsweise 20 µm in eine Vielzahl von Schichten unterteilt ist, deren Dicke jeweils 0,01 bis 2 µm beträgt. Zwischen diesen Aluminiumoxidschichten sind dann anderweitige Schichten, wie beispielsweise Titancarbid, Titannitrid usw. untergebracht. Es handelt sich somit um einen Sandwichaufbau.

Davon ausgehend ist es Aufgabe der Erfindung das Schneidwerkzeug zu verbessern.

Diese Aufgabe wird mit den Merkmalen des Anspruchs 1 gelöst:
Das erfindungsgemäße Schneidwerkzeug weist einen Grundkörper auf, der mit einem Schichtaufbau versehen ist, der zumindest eine einphasige, metastabile ternäre Oxidschicht trägt. Die ternäre Oxidschicht enthält, neben Sauerstoff, zumindest zwei andere chemische Elemente, z.B. Aluminium und Chrom. In einer anderen Variante enthält das Oxid Aluminium und Zirkonium. Eines der Elemente, z.B. Aluminium, wird als Hauptkomponente und das andere, z.B. Chrom oder Zirkonium als Nebenkomponente bezeichnet. Jedenfalls aber sind beide Elemente einer Gruppe entnommen, zu der die vierte, die fünfte und die sechste Nebengruppe des periodischen Systems der chemischen Elemente gehören. Zusätzlich gehören Aluminium und Silizium in diese Gruppe. Beispielsweise ist ein erfindungsgemäße ternäre Oxidschicht eine Aluminiumzirkoniumoxidschicht, die als kristalline Schicht die Kristallstruktur von Aluminiumoxid aufweist, wobei einige der Aluminium-Kristallgitterplätze von Zirkoniumatomen besetzt sind. Die Schicht ist dabei jedoch so aufgebaut, dass das Oxid in einer einzigen metastabilen Phase vorliegt, d.h. es sind keine binären Oxidkristalle in die Oxidschicht eingelagert. Die Besetzung einzelner Aluminiumgitterplätze durch Zirkonium führt zu einer Verspannung des Kristallgitters des Oxids, was eine wesentliche Härtung desselben bedeuten kann. Somit erschließt der Merkmalskomplex des Anspruchs 1 den Weg zu oxidischen Schichten mit vergrößerter Härte.

Je nach Wahl der Hauptkomponente und der Nebenkomponente, kann das Gitter durch positive Druckspannungen oder negative Zugspannungen verspannt sein. Ist Aluminium die Hauptkomponente und Zirkonium die Nebenkomponente, führt dies zu Druckspannungen in dem Kristallgitter. Ist hingegen Zirkonium die Hauptkomponente und Aluminium die Nebenkomponente, führt dies zu Zugspannungen. Die Wahl der Atomprozente der Hauptkomponente und der Nebenkomponente wird dabei jeweils in Abhängigkeit von dem verwendeten Elementen so getroffen, dass die Oxidschicht in einer einzigen Phase vorliegt, so dass nicht zwei Phasen nebeneinander vorliegen. Solche metastabilen Schichten lassen sich vorzugsweise im PVD abscheiden.

Die Oxidschicht kann außer der Hauptkomponente, der Nebenkomponente und Sauerstoff gemäß Anspruch 2 ein weiteres chemisches Element enthalten, bspw. ein aus der genannten Gruppe ausgewähltes Element. Z.B. kann im Falle von (Al, Zr)₂O₃) Chrom als zusätzliche Nebenkomponente dienen, was zur Ausbildung einer (Al, Zr, Cr)₂O₃) -Schicht führt. Die ist im PVD mit Mischtargets oder gesonderten Targets möglich. Damit lassen sich gezielt weitere Härteverbesserungen sowie, zumindest bis zu einem gewissen Grad, auch eine Verringerung der Sprödigkeit der Oxidschicht erreichen.

Die Oxidschicht ist vorzugsweise ein Substitutionsmischkristall in mono- oder polykristalliner Form. Durch geeignete Prozessführung lässt sich das Verhältnis zwischen der Hauptkomponente und der Nebenkomponente innerhalb der Schicht in einer Richtung senkrecht zur Schicht variieren. Beispielsweise kann ein deutlicher Gradient der Nebenkomponente von einer Seite zu der anderen Seite der Schicht hin gewünscht und erzeugt werden. Damit lassen sich Schichten erzeugen, die bspw. an ihrer Grundfläche einen anderen Spannungszustand haben wie an ihrer Oberseite. Die Schicht lässt sich auch in Subschichten unterteilen, bspw. in dem der prozentuale Anteil der Nebenkomponente von der Grundseite der Schicht bis zur Oberseite hin ein- oder mehrmals zwischen verschiedenen Werten variiert wird. Dadurch lassen sich besondere Zähigkeits- oder Festigkeitseigenschaften erreichen.

Die Nebenkomponente macht eine Anteil an der Gesamtatomzahl der oxidischen Schicht von größer 1 Atomprozent aus. Sie stellt nicht lediglich eine Verunreinigung dar.

Alternativ zu der metastabilen ternären Oxidschicht kann das Schneidwerkzeug auch mit einer Schicht versehen sein, die zweiphasig ist, wobei eine Phase in amorpher Matrixphase vorliegt und die zweite Phase aus einem Oxid besteht. Die Kombination einer amorphen Phasen mit der oxidischen kristallinen Phase eröffnet den Weg zu besonderen Eigenschaften, insbesondere hinsichtlich hoher Härte kombiniert mit hoher Zähigkeit.

Das Oxid ist vorzugsweise ein Oxid eines oder mehrerer Elemente der vierten, fünften oder sechsten Nebengruppe des periodischen Systems der Elemente, Aluminium oder Silizium. Es kann ein binäres Oxid sein, das lediglich einen aus der vorgenannten Gruppe ausgewählten Stoff enthält. Vorzugsweise können aber auch ternäre oder noch komplexere Oxide verwendet werden. In den Kristalliten bilden sie dann bspw. Substitutionsmischkristalle, die in die amorphe Phase eingebettet sind. Wird ein ternäres Oxid verwendet, entstammen die beteiligten Elemente vorzugsweise der oben genannten Gruppe, wobei sie in unterschiedlichen Gehalten vorhanden sind. Alternativ können jedoch auch zwei binäre Oxide nebeneinander als Kristallite eingebettet in die amorphe Phase vorliegen.

Die amorphe Phase ist vorzugsweise eine kovalent gebundene Schicht. Sie kann eine CN-Schicht, die nur aus Kohlenstoff und Stickstoff besteht, eine Oxidschicht oder eine keramische Schicht sein. Eine keramische Schicht ist bspw. eine Siliziumkarbidschicht. Alternativ kann als amorphe Phase eine metallische Hartstoffschicht zur Anwendung kommen.

Der Schichtaufbau kann weitere Schichten enthalten, die ebenso wie die Schichten nach Anspruch 1 oder 10 aufgebaut sind. Alternativ oder zusätzlich können weitere Schichten, bspw. metallische Hartstoffschichten gemäß Anspruch 20 oder einen Schichtaufbau gemäß Anspruch 21 aufweisen. Vorzugsweise wird die erfindungsgemäße Schicht und weiter vorzugsweise der gesamte Schichtaufbau in einem PVD-Verfahren erzeugt.

In der Zeichnung sind Ausführungsbeispiele der Erfindung veranschaulicht. Es zeigen:
- Fig. 1: ein Schneidwerkzeug in perspektivischer schematischer Darstellung,
- Fig. 2: das Schneidwerkzeug nach Figur 1, in einer ausschnittsweisen geschnittenen Darstellung,
- Fig. 3: eine alternative Ausführungsform des Schneidwerkzeugs nach Figur 1 in einer geschnittenen ausschnittsweisen Darstellung und
- Fig. 4: eine alternative Ausführungsform eines Schichtaufbaus eines Schneidwerkzeugs nach Figur 1.

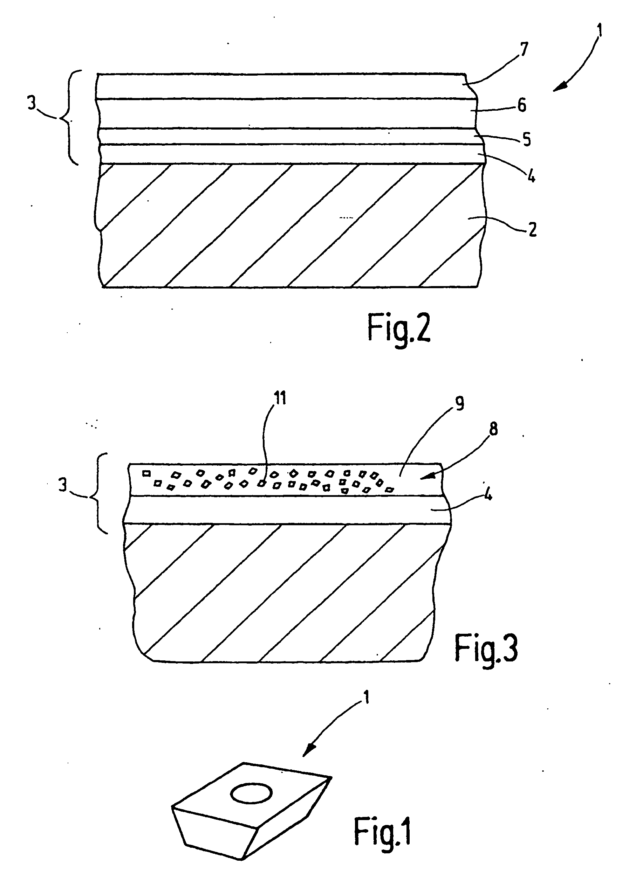

In Figur 1 ist eine Schneidplatte 1 als Beispiel für ein Schneidwerkzeug veranschaulicht. Die Schneidplatte 1 besteht aus einem Grundkörper 2, der in Figur 2 angeschnitten dargestellt ist und bspw. aus Kobalt gebundenem gesinterten Wolframcarbid besteht. Der Grundkörper 2 trägt einen Schichtaufbau 3, der bspw. mittels PVD-Verfahren aufgebracht worden ist. Er weist vorzugsweise eine Dicke zwischen 5 µm und 30 µm auf. Der Schichtaufbau besteht vorzugsweise aus mehreren einzelnen Schichten 4, 5, 6, 7, die unterschiedliche Zusammensetzungen haben können. Beispielsweise sind die unteren auf dem Grundkörper 2 haftenden Schichten 4, 5, Schichten auf Titanbasis, wie bspw. Titannitrid oder Titancarbonitrid oder Ähnliches. Die Schicht 5 kann alternativ als haftungsvermittelnde Schicht für eine darüber liegende oxidische Schicht 6 ausgebildet sein. Die oxidische Schicht 6 besteht aus einem ternären Oxid in metastabiler Phase. Es handelt sich bspw. um (Al, Zr)₂O₃, d.h. um ein Aluminiumoxid, bei dem einige Aluminiumatome durch Zirkoniumatome ersetzt sind. Aluminium bildet eine Hauptkomponente und Zirkonium eine Nebenkomponente. Sie macht vorzugsweise weniger als 10%, weiter vorzugsweise lediglich 3 oder 4 at% des Metallanteils aus. Es handelt sich um einen Substitutionsmischkristall, der in einer einzigen Phase vorliegt. Kristallite von Al₂O₃ oder ZrO₂ sind nicht vorhanden (d.h. keine Spinellstruktur). Der Zirkoniumgehalt liegt deutlich über ein Atomprozent, wobei er so festgelegt wird, dass die Schicht 6 die gewünschte Festigkeit erhält.
Die Schicht 6 ist in einem PVD-Reaktivprozess erzeugt worden. Beispielsweise in einer PVD-Beschichtungsanlage mit AlZr-Mischtargets. Ein solches Target kann bspw. im Wesentlichen aus Aluminium bestehen und ungefähr zwei Atomprozent Zirkonium enthalten. In der PVD-Beschichtungsanlage wird in einer geschlossenen Magnetfeldanordnung eine Plasmaatmosphäre mit niedrigem Druck von z.B. 0,8 Pa erzeugt. Sie besteht im Wesentlichen aus Argon mit Sauerstoff. Es wird ein PVD-Magnetronverfahren angewandt, bei dem vor dem Target ein Argonplasma gezündet wird. Es kommt zur Hochleistungskatodenzerstäubung (gepulstes DC-Magnetronsputtern). Die Pulsfrequenz bein Magnetronsputtern kann z.B. auf 90 kHz mit einer On-Time von 80% (Puls-Pause-Verhältnis von 4 zu 1) festgelegt sein. Vorteilhaft ist eine gepulste Substratvorspannung (Bias) von -200 V mit einer Pulsfrequenz von 70 kHz. Die Substrattemperatur kenn bei 650°C gehalten werden. Der so von dem Target mit einer spezifischen Targetleistung von ca. 6 W/cm² erzeugte Aluminium- und Zirkoniumdampf scheidet sich unter Zugabe des Reaktivgases Sauerstoff als einphasiger metastabiler Mischkristall als Schicht 6 ab. Die Zirkoniumatome werden in eine sich ausbildende γ-Aluminiumoxidschicht (auf Aluminium-Gitterplätzen) eingelagert und erzeugen in dem Al₂O₃-Kristall Gitterverspannungen. Die Verspannung der Schicht härtet diese. Die Schicht hat eine Dicke von 0,5 bis 10 µm, vorzusweise 2 bis 4 µm. Je nach gewünschter Schichtdicke beträgt die Abscheidedauer 30 min. bis 6 h.

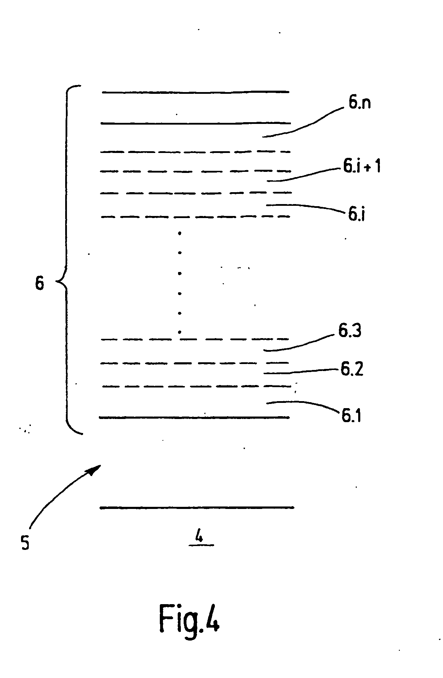

Es können auch getrennte Aluminiumtargets und Zirkoniumtargets verwendet werden. Dies hat den Vorteil, dass durch die Steuerung der Katodenzerstäubung an dem jeweiligen Target das Mischungsverhältnis zwischen Aluminium (Hauptkomponente) und Zirkonium (Nebenkomponente) wie gewünscht eingestellt oder auch innerhalb einer Schicht moduliert werden kann. Die erzeugte mindestens ternäre Oxidschicht kann auch als Multilayerschicht ausgebildet sein. Z.B. kann dies durch periodische Variation des Targetbeschusses oder der Zusammensetzung der Prozessatmosphäre erreicht werden, z.B. indem von Zeit zu Zeit geringe Stickstoffanteile eingeleitet werden. Es ergibt sich eine ternäre oxidische Multilayerschicht, in die Oxidnitridlagen eingelagert sind. Es können in die ternäre Oxidschicht auch Lagen binären Oxids eingelagert sein. Ein Beispiel für eine solche Mehrlagenstrukturierung der Schicht 6 ist in Figur 4 veranschaulicht. Die Schicht 6 ist in eine Anzahl von Lagen 6.1 bis 6.n unterteilt, die voneinander unterscheidbar sind. Wenigstens eine dieser Lagen 6.1 bis 6.n ist eine einphasige metastabile, zumindest ternäre Oxidschicht. Wenigstens eine der übrigen Lagen unterscheidet sich von dieser Oxidschicht durch ihre chemische Zusammensetzung und/oder strukturell. Sie kann ebenfalls eine einphasige ternäre Oxidschicht mit einer anderen chemischen Zusammensetzung oder lediglich anderen Atomprozentzahlen der beteiligten Elemente sein. Beispielsweise kann die Lage 6.1 eine (Al, Zr)₂O₃-Schicht und die Lage 6.2 eine Al₂O₃-Schicht sein. Auf diese Weise kann sich jeweils eine ternäre (oder höhere) Oxidschicht mit einer binären Oxidschicht abwechseln. Die zwischen den zumindest ternären Oxidlagen können sich jedoch auch durch andere Merkmale von den ternären Oxidlagen unterscheiden. Beispielsweise können sie mehrphasig sein oder zusätzliche andere chemische Elemente enthalten oder auch Elemente der metastabilen ternären Oxidlage nicht enthalten. Auf diese Weise können die einzelnen Lagen der Multilayerschicht z.B. gegeneinander verspannt werden, um gezielt mechanische Eigenschaften zu beeinflussen.

Die Targetvorspannung wird vorzugsweise mit 10 bis 100 kHz gepulst. Vorzugsweise wird bipolar gepulst, wobei die negative Spannung zwischen -200 und -400 V liegt und die positive Spannung vorzugsweise um +100 V liegt. Vorzugsweise wird im Gegentakt gepulst. Z.B. können zwei Al-Zr-Mischtargets mit einem Zusammensetzungsverhältnis von 97at% zu 3at% Anwendung finden. Sie werden in Dualmagnetron bipolar gepulst. Es kann mit einer Prozesstemperatur von 600°C oder darüber und einer Substratvorspannung von -80V gearbeitet werden. Der Prozessdruck kann z.B. 0,7 Pa Argon betragen. Als Reaktivgas wird Sauerstoff zugeführt.

Es können unter folgenden Bedingungen auch durch Einlagerung von Chrom in Aluminiumoxid verspannte und dadurch gehärtete (Al, Cr)₂O₃-Schichten (ternäre Oxidschicht) erzeugt werden:
- Gepulstes DC Magnetronsputtern (z.B. bipolar, 80 kHz, On-Time 80%),
- Druck: 0,8 Pa
- Gepulste Substratvorspannung (Bias):-150V (bipolar, 70 kHz)
- Temperatur: 600°C
- Target: Aluminium-Chrom-Mischtarget mit 1 bis 6 at% Cr
- Spezifische Targetleistung: ca. 6 W/cm²
- Geschlossene Magnetfeldanordnung
- Abscheidungsdauer: je nach gewünschter Schichtdicke 30 min bis 6 h
- Schichtdicke: 0,5 bis 10 µm, vorzusweise 2 bis 4 µm.

Aluminium bildet die Hauptkomponente und Chrom die Nebenkomponente. Sie macht vorzugsweise weniger als 10%, weiter vorzugsweise lediglich 3 oder 4 at% des Metallanteils aus.

Auf der Schicht 6 kann eine weitere Schicht z.B. die Schicht 7 als Dekorschicht aufgebracht werden. Diese kann farbig sein, als Verschleißindikator wirken oder Reibeigenschaften ändern. Der Schichtaufbau 3 kann auch abweichend gestaltet werden. Beispielsweise können zwischen die Schicht 4 und die Schicht 6 weitere Schichten eingefügt werden, die bspw. als metallische Hartstoffschichten ausgebildet sind. Dies können TiAlN-Schichten, TiCN-Schichten, AlCr(O,N)-Schichten, eine Nitrid-, Karbid-, Karbonnitrid- oder Oxocarbonitridschicht eines oder mehrerer Metalle der vierten, fünften oder sechsten Nebengruppe des periodischen Systems der chemischen Elemente sein. Außerdem können ein oder mehrere zusätzliche Schichten der Zusammensetzung (Me1, Me2, ...)* (O,B,C,N) mit dominierendem Sauerstoffanteil bei den Nichtmetallen vorgesehen werden, wobei die beteiligten Metalle Me1, Me2, ... bei einer Gruppe entnommen sind zu der die vierte, fünfte oder sechste Nebengruppe des Periodensystems sowie Aluminium und Silizium gehören. Es handelt sich dann um eine ternäre oder komplexere, vorwiegend oxidische, Schicht.

In Figur 3 ist eine abgewandelte Ausführungsform des Schichtaufbaus 3 veranschaulicht. Dieser enthält zumindest eine Schicht 8, die als zweiphasige Schicht ausgebildet ist. Darüber oder darunter kann eine weitere Schichte 4 vorgesehen sein, die z.B. Als TiN-Schicht oder als sonstige Schicht ausgebildet sit.

Die zweiphasige Schicht 8 enthält eine amorphe Matrix 9, die bspw. durch eine kovalent gebundene, d.h. nichtmetallische und im Wesentlichen auch kein Metall enthaltende CN-Schicht gebildet ist. In diese kovalent gebundene amorphe Matrix sind Kristallite 11 eingelagert, die oxidisch sind. Sie bestehen bspw. aus Aluminiumoxid, Zirkoniumoxid oder einem anderen binären Oxid. Das oxidierte Metall ist vorzugweise der vierten, fünften oder sechsten Nebengruppe des Periodensystems entnommen oder es handelt sich um Aluminium oder Silizium. Diese Kristallite 11 bilden eine zweite Phase. Es können weitere Phasen während der dritte, vierte, fünfte Phase usw. aus anderen Oxiden oder anderen Stoffen vorgesehen sein. Des weiteren können die Kristallite 11 durch ternäre Oxide gebildet sein, wie sie oben im Zusammenhang mit der Schicht 6 beschrieben worden sind. Das Zusammenspiel zwischen der amorphen Matrixphase und einer zweiten oxidischen Phase eröffnet die Möglichkeit zur Schaffung von Beschichtungen, die sowohl hart als auch zäh sind. Die eingelagerten Kristallite können ternäre Oxide der vorbeschiebenen Art sein.

Im PVD-Verfahren werden Schneidwerkzeuge mit einer Schicht versehen, die ein einphasiges ternäres oder komplexeres Oxid ist. Durch geeignete Festlegung der Atomprozente der beteiligten Hauptkomponente und der beteiligten Nebenkomponente lassen sich Verspannungen des gebildeten Oxids gezielt steuern und zur Beeinflussung seiner Eigenschaften ausnutzen. Alternativ kann die Schicht eine amorphe Matrixphase und darin eingebettete Oxidkristallite aufweisen. Die Oxidkristallite können binär, ternär oder komplexer sein. Es können ein oder mehrere verschiedene Kristallitsorten nebeneinander vorliegen.

## Patentansprüche

1. Schneidwerkzeug (1) mit einem Grundkörper (2), der einen Schichtaufbau (3) mit wenigstens einer einphasigen metastabilen zumindest ternären im PVD-Verfahren erzeugten Oxidschicht (6) trägt, die als Substitutionsmischkristall vorliegt,
die eine Hauptkomponente und mindestens eine Nebenkomponente aufweist,
wobei die Hauptkomponente den überwiegenden Anteil und die Nebenkomponente mit einem Anteil von mehr als 1 at% und bis zu 4 at% einen geringeren Anteil ausmacht,
wobei die Hauptkomponente Aluminium und die Nebenkomponente Chrom oder Titan oder Zirkon ist und
wobei die ternäre Oxidschicht die Struktur einer γ-Aluminiumoxidschicht aufweist.

2. Schneidwerkzeug nach Anspruch 1, **dadurch gekennzeichnet, dass** die Oxidschicht (6) ein weiteres chemisches Element enthält.

3. Schneidwerkzeug nach Anspruch 1, **dadurch gekennzeichnet, dass** es zumindest zwei Schichten gemäß Anspruch 1 aufweist, zwischen denen wenigstens eine weitere Schicht angeordnet ist.

4. Schneidwerkzeug nach Anspruch 3, **dadurch gekennzeichnet, dass** die weitere Schicht ebenfalls gemäß Anspruch 1 ausgebildet ist, in ihrer Zusammensetzung jedoch von den benachbarten Schichten verschieden ist.

5. Schneidwerkzeug nach Anspruch 1 , **dadurch gekennzeichnet, dass** der Schichtaufbau (3) weitere Schichten aufweist.

6. Schneidwerkzeug nach Anspruch 5, **dadurch gekennzeichnet, dass** der Schichtaufbau (3) wenigstens eine metallische Hartstoffschicht enthält, die eine TiAlN-Schicht, eine AlCr-Schicht, eine Nitrid-, Carbid-, Carbonitrid- oder Oxocarbonitridschicht eines oder mehrerer Metalle der IV., V. oder VI. Nebengruppe des periodischen Systems der chemischen Elemente ist.

7. Schneidwerkzeug nach Anspruch 5, **dadurch gekennzeichnet, dass** der Schichtaufbau (3) wenigstens eine Schicht eines ternären oder komplexeren Metalloxid der Zusammensetzung (Me1, Me2, ...)x(O, B, C, N) mit dominierendem Sauerstoffanteil bei den Nichtmetallen ist, wobei die beteiligten Metalle Me1, Me2, ... einer Gruppe entnommen sind, zu der die IV., V. oder VI. Nebengruppe des periodischen Systems der chemischen Elemente, Aluminium und Silizium gehören.

## Claims

1. Cutting tool (1) with a base body (2), which bears a layer structure (3) with at least one single-phase metastable at least ternary oxide layer (6) produced using the PVD process, which is present as a substitution mixed crystal,
which has a main component and at least one secondary component,
wherein the main component forms the predominant proportion and the secondary component forms a smaller proportion with a proportion of more than 1 at. % and up to 4 at. %,
wherein the main component is aluminium and the secondary component is chromium or titanium or zirconium, and
wherein the ternary oxide layer has the structure of a γ-aluminium oxide layer.

2. Cutting tool according to claim 1, **characterised in that** the oxide layer (6) contains a further chemical element.

3. Cutting tool according to claim 1, **characterised in that** it has at least two layers according to claim 1, between which at least one further layer is arranged.

4. Cutting tool according to claim 3, **characterised in that** the further layer is also configured according to claim 1, but differs from the adjacent layers in its composition.

5. Cutting tool according to claim 1, **characterised in** the layer structure (3) has further layers.

6. Cutting tool according to claim 5, **characterised in that** the layer structure (3) contains at least one metallic hard material layer, which is a TiAIN layer, an AlCr layer, a nitride, carbide, carbonitride or oxocarbonitride layer of one or more metals of subsidiary group IV, V or VI of the periodic system of chemical elements.

7. Cutting tool according to claim 5, **characterised in that** the layer structure (3) is at least one layer of a ternary or more complex metal oxide of the composition (Me1, Me2, ...) x (O, B, C, N) with dominant oxygen component in the case of the nonmetals, wherein the included metals Me1, Me2, ... are taken from a group, to which subsidiary group IV, V or VI of the periodic system of chemical elements, aluminium and silicon belong.

## Revendications

1. Outil de coupe (1), comprenant un corps de base (2) qui porte une structure stratifiée (3) avec au moins une couche d'oxyde (6) métastable à phase unique, qui est au moins ternaire, est produite par un procédé de dépôt physique en phase vapeur (PVD) et se présente sous forme de solution solide de substitution,
qui comporte un constituant principal et au moins un constituant secondaire,
le constituant principal représentant la fraction majoritaire, et le constituant secondaire, avec une part supérieure à 1 % at et allant jusqu'à 4 % at, représentant une fraction plus faible,
le constituant principal étant de l'aluminium et le constituant secondaire étant du chrome ou du titane ou du zirconium, et
la couche d'oxyde ternaire présentant la structure d'une couche d'oxyde d'aluminium γ.

2. Outil de coupe selon la revendication 1, **caractérisé par le fait que** la couche d'oxyde (6) comporte un élément chimique supplémentaire.

3. Outil de coupe selon la revendication 1, **caractérisé par le fait qu'**il présente au moins deux couches selon la revendication 1, entre lesquelles est disposée au moins une couche supplémentaire.

4. Outil de coupe selon la revendication 3, **caractérisé par le fait que** la couche supplémentaire est également réalisée conformément à la revendication 1, mais que sa composition est différente de celle des couches contiguës.

5. Outil de coupe selon la revendication 1, **caractérisé par le fait que** la structure stratifiée (3) comporte des couches supplémentaires.

6. Outil de coupe selon la revendication 5, **caractérisé par le fait que** la structure stratifiée (3) comporte au moins une couche de matériau dur métallique, qui est une couche de TiAIN, une couche de AlCr, une couche de nitrure, de carbure, de carbonitrure ou d'oxycarbonitrure d'un ou de plusieurs métaux du sous-groupe IV, V ou VI de la classification périodique des éléments chimiques.

7. Outil de coupe selon la revendication 5, **caractérisé par le fait que** la structure stratifiée (3) est au moins une couche d'un oxyde métallique ternaire ou plus complexe, ayant la composition (Me1, Me2, ...) x (O, B, C, N) à fraction d'oxygène dominante pour les non-métaux, les métaux participants Me1, Me2, ... étant pris dans un groupe auquel appartiennent les sous-groupes IV, V ou VI de la classification périodique des éléments chimiques, l'aluminium et le silicium.
